# EUROPEAN PATENT SPECIFICATION

(11) **EP 2 528 974 B1**
(45) Date of publication and mention of the grant of the patent: **18.10.2017**
(21) Application number: 11704094.9
(22) Date of filing: 20.01.2011
(51) Int. Cl.: C08L 83/04, C08K 3/20, H01L 21/52, C08G 77/20

(54) **THERMALLY CONDUCTIVE SILICONE RUBBER COMPOSITION**
WÄRMELEITENDE SILIKON-KAUTSCHUK-ZUSAMMENSETZUNG
COMPOSITION DE CAOUTCHOUC DE SILICONE THERMIQUEMENT CONDUCTEUR

(30) Priority: 28.01.2010 JP 2010016719
(43) Date of publication of application: 05.12.2012
(73) Proprietor: Dow Corning Toray Co., Ltd., Tokyo, 100-0004 (JP)
(72) Inventor: KODAMA, Harumi, Ichihara-shi Chiba 299-0108 (JP); ONISHI, Masayuki, Ichihara-shi Chiba 299-0108 (JP); SAKAGUCHI, Ryo, Ichihara-shi Chiba 299-0108 (JP); NAKAYOSHI, Kazumi, Ichihara-shi Chiba 299-0108 (JP)
(74) Representative: Murgitroyd & Company
(86) International application number: PCT/JP2011/051538
(87) International publication number: WO 2011/093353

(56) References cited:
- US-A1- 2009 230 348

## Description

### Technical Field

The present invention relates to a thermally conductive silicone rubber composition.

Priority is claimed on Japanese Patent Application No. 2010-016719, filed on January 28, 2010.

### Background Art

Accompanying the increase in recent years in the density and level of integration of hybrid ICs and printed circuit boards mounted with electronic components such as transistors, ICs, memory elements, and so forth, various types of thermally conductive silicone rubber compositions are being used for the purpose of very efficiently dissipating the heat from these electronic components. The following have been proposed for these thermally conductive silicone rubber compositions: a thermally conductive silicone rubber composition comprising a vinyl group-containing organopolysiloxane, an organohydrogenpolysiloxane, a thermally conductive filler selected from alumina, quartz powder, magnesia, boron nitride, and silicon carbide, an adhesion promoter selected from aminosilanes, epoxysilanes, and alkyl titanates, and a platinum-type catalyst {see Japanese Unexamined Patent Application Publication (hereinafter referred to as "Kokai") Sho 61-157569}; a thermally conductive silicone rubber composition comprising an organopolysiloxane that contains at least 0.1 mole% aliphatically unsaturated groups in each molecule, an organohydrogenpolysiloxane that has at least two silicon-bonded hydrogen atoms in each molecule, a finely divided spherical alumina powder having an average particle size of 10 to 50 µm, a finely divided spherical or nonspherical alumina powder having an average particle size of less than 10 µm, and platinum or a platinum-type compound (see Kokai Sho 63-251466); a thermally conductive silicone rubber composition comprising an alkenyl group-containing organopolysiloxane, an organohydrogenpolysiloxane, an irregularly shaped finely divided alumina powder having an average particle size of 0.1 to 5 µm, a finely divided spherical alumina powder having an average particle size of 5 to 50 µm, and a platinum-type catalyst (see Kokai Hei 02-041362); and a thermally conductive silicone rubber composition comprising an alkenyl group-containing organopolysiloxane that contains an average of at least 0.5 alkenyl groups in each molecule, an organohydrogenpolysiloxane that contains at least two silicon-bonded hydrogen atoms in each molecule, a high-purity finely divided alumina powder that has an average particle size of not more than 50 µm and a major axis to minor axis ratio of 1.0 to 1.4, and a platinum-type catalyst (see Kokai Hei 05-105814).

A problem with these thermally conductive silicone rubber compositions, however, is that they contaminate the surrounding substrate due to an oil fraction that bleeds out from the composition during the course of curing and a low-boiling fraction that volatilizes from the composition during the course of curing.

As a consequence, Kokai Hei 04-311764 proposes a silicone rubber composition comprising an organopolysiloxane that has an alkenyl group at both molecular chain terminals and that has undergone chain length extension by an organopolysiloxane that has two SiH groups in each molecule, an organohydrogenpolysiloxane that has at least two SiH groups in each molecule, and a platinum group metal-type catalyst; the content in this composition of each low molecular weight siloxane component up to a degree of polymerization of 20 is suppressed to 100 ppm or less. This silicone rubber composition may also incorporate a thermally conductive filler such as boron nitride, aluminum oxide, and so forth. In addition, Kokai 2005-175119 proposes a silicone rubber composition comprising an organopolysiloxane that has at least two silicon-bonded alkenyl groups in each molecule, an organopolysiloxane that has at least two silicon-bonded hydrogen atoms in each molecule and that exhibits a loss on heating at 100°C x 1 hour of not more than 5 weight%, an adhesion promoter that contains a silicon-bonded alkoxy group and that does not contain a silicon-bonded hydrogen atom, and a platinum-type catalyst; this silicone rubber composition may also contain alumina.

However, even these silicone rubber compositions have the problem of not providing a satisfactory reduction in the oil fraction that bleeds out from the composition during the course of curing.

An object of the present invention is to provide a thermally conductive silicone rubber composition that is characterized by reduced oil fraction that bleeds out from the composition during the course of curing, and by reduced low-boiling fraction that volatilizes from the composition during the course of curing.

### Disclosure of Invention

The present disclosure relates to a thermally conductive silicone rubber composition as defined in claim 1.

### Effects of Invention

The thermally conductive silicone rubber composition of the present invention is characterized by reduced oil fraction that bleeds out from the composition during the course of curing, and by reduced low-boiling fraction that volatilizes from the composition during the course of curing.

### Brief Description of the Drawing

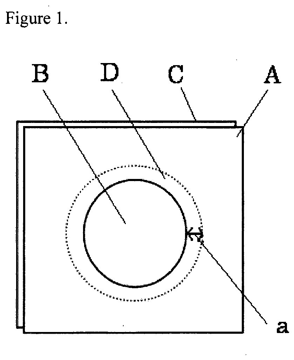

Figure 1 contains an oblique view of a test specimen for evaluating the oil bleed behavior of a thermally conductive silicone rubber composition.

Reference Numerals Used in the Description
- A: ground glass
- B: silicone rubber
- C: ground glass
- D: oil fraction
- a: width of oil bleed out

### Detailed Description of the Invention

The organopolysiloxane of component (A) is the base component of the composition, contains at least two silicon-bonded alkenyl groups in each molecule, does not contain silicon-bonded hydroxyl group, and does not contain silicon-bonded alkoxy group. The silicon-bonded alkenyl group in component (A) can be exemplified by vinyl, allyl, butenyl, pentenyl, hexenyl, and heptenyl, wherein vinyl is particularly preferred. Silicon-bonded organic groups other than the alkenyl groups in component (A) can be exemplified by alkyl groups such as methyl, ethyl, propyl, butyl, pentyl, hexyl, heptyl, and so forth; aryl groups such as phenyl, tolyl, xylyl, naphthyl, and so forth; aralkyl groups such as benzyl, phenethyl, and so forth; and halogenated alkyl groups such as chloromethyl, 3-chloropropyl, 3,3,3-trifluoropropyl, and so forth; wherein methyl and phenyl groups are particularly preferred. There are no limitations on the molecular structure of component (A), and its molecular structure can be exemplified by linear chain, partially branched linear chain, and branched chain, wherein linear chain is particularly preferred.

While there are no limitations on the viscosity of component (A) at 25°C, the viscosity at 25°C is preferably in the range from 10 to 500,000 mPa·s and particularly preferably in the range from 50 to 100,000 mPa·s. The reasons for this are as follows: the physical properties of the obtained silicone rubber are excellent when the viscosity of component (A) is at least the lower limit on the indicated range; on the other hand, the resulting composition exhibits better handling characteristics at not more than the upper limit on the indicated range.

Component (A) must also have a content of cyclic siloxanes having from 4 to 20 siloxane units of not more than 1,000 ppm and preferably not more than 500 ppm, in each case in mass units. The reason for this is as follows: the low-boiling fraction that volatilizes from the obtained composition during the course of its cure can be more significantly reduced when the content of the cyclic siloxanes having from 4 to 20 siloxane units in component (A) is not more than the upper limit on the indicated range. The cyclic siloxanes can be exemplified by cyclic dimethylsiloxane oligomers, cyclic methylvinylsiloxane oligomers, cyclic methylphenylsiloxane oligomers, and cyclic co-oligomers of a dimethylsiloxane and a methylvinylsiloxane. The content of cyclic siloxanes having from 4 to 20 siloxane units in component (A) can be measured by analysis by, for example, gas chromatography.

The organopolysiloxane of component (A) can be exemplified by a copolymer of a dimethylsiloxane and a methylvinylsiloxane endblocked by trimethylsiloxy groups at both molecular chain terminals; a methylvinylpolysiloxane endblocked by trimethylsiloxy groups at both molecular chain terminals; a copolymer of a dimethylsiloxane, a methylvinylsiloxane and a methylphenylsiloxane endblocked by trimethylsiloxy groups at both molecular chain terminals; a dimethylpolysiloxane endblocked by dimethylvinylsiloxy groups at both molecular chain terminals; a methylvinylpolysiloxane endblocked by dimethylvinylsiloxy groups at both molecular chain terminals; a copolymer of a dimethylsiloxane and a methylvinylsiloxane endblocked by dimethylvinylsiloxy groups at both molecular chain terminals; a copolymer of a dimethylsiloxane, a methylvinylsiloxane and a methylphenylsiloxane endblocked by dimethylvinylsiloxy groups at both molecular chain terminals; an organopolysiloxane copolymer comprising a siloxane unit represented by the formula: R¹₃SiO_{1/2}, a siloxane unit represented by the formula: R¹₂R²SiO_{1/2}, a siloxane unit represented by the formula: R¹₂SiO_{2/2}, and a small amount of a siloxane unit represented by the formula: SiO_{4/2}; an organopolysiloxane copolymer comprising a siloxane unit represented by the formula: R¹₂R²SiO_{1/2}, a siloxane unit represented by the formula: R¹₂SiO_{2/2}, and a small amount of a siloxane unit represented by the formula: SiO_{4/2}; an organopolysiloxane copolymer comprising a siloxane unit represented by the formula: R¹R²SiO_{2/2} and a small amount of a siloxane unit represented by the formula: R¹SiO_{3/2} or a siloxane unit represented by the formula: R²SiO_{3/2}; and mixtures of two or more of the above organopolysiloxanes. In the above formulas, R¹ is a monovalent hydrocarbon group other than the alkenyl group and can be exemplified by alkyl groups such as methyl, ethyl, propyl, butyl, pentyl, hexyl, heptyl, and so forth; aryl groups such as phenyl, tolyl, xylyl, naphthyl, and so forth; aralkyl groups such as benzyl, phenethyl, and so forth; and halogenated alkyl groups such as chloromethyl, 3-chloropropyl, 3,3,3-trifluoropropyl, and so forth. In the above formulas, R² is an alkenyl group, for example, vinyl, allyl, butenyl, pentenyl, hexenyl, heptenyl, and so forth.

The organopolysiloxane of component (B) is a crosslinker for the composition, contains at least two silicon-bonded hydrogen atoms in each molecule, does not contain a silicon-bonded alkenyl group, does not contain a silicon-bonded hydroxyl group, and does not contain a silicon-bonded alkoxy group. Silicon-bonded organic groups in component (B) can be exemplified by alkyl groups such as methyl, ethyl, propyl, butyl, pentyl, hexyl, heptyl, and so forth; aryl groups such as phenyl, tolyl, xylyl, naphthyl, and so forth; aralkyl groups such as benzyl, phenethyl, and so forth; and halogenated alkyl groups such as chloromethyl, 3-chloropropyl, 3,3,3-trifluoropropyl, and so forth, wherein methyl and phenyl gorups are particularly preferred. There are no limitations on the molecular structure of component (B), and the molecular structure of component (B) can be exemplified by linear chain, partially branched linear chain, and branched chain wherein linear chain is particularly preferred.

Although there are no limitations on the viscosity of component (B) at 25°C, it is preferably in the range from 1 to 500,000 mPa·s and particularly preferably in the range from 5 to 100,000 mPa·s. The reasons for this are as follows: the obtained silicone rubber has excellent physical properties when the viscosity of component (B) is at least the lower limit on the indicated range; on the other hand, the obtained composition has excellent handling characteristics at not more than the upper limit on the indicated range.

The organopolysiloxane of component (B) can be exemplified by a methylhydrogenpolysiloxane endblocked by trimethylsiloxy groups at both molecular chain terminals; a copolymer of a dimethylsiloxane and a methylhydrogensiloxane endblocked by trimethylsiloxy groups at both molecular chain terminals; a copolymer of a dimethylsiloxane, a methylhydrogensiloxane and a methylphenylsiloxane endblocked by trimethylsiloxy groups at both molecular chain terminals; a dimethylpolysiloxane endblocked by dimethylhydrogensiloxy groups at both molecular chain terminals; a copolymer of a dimethylsiloxane and a methylphenylsiloxane endblocked by dimethylhydrogensiloxy groups at both molecular chain terminals; a methylphenylpolysiloxane endblocked by dimethylhydrogensiloxy groups at both molecular chain terminals; an organopolysiloxane copolymer comprising a siloxane unit represented by the formula: R¹₃SiO_{1/2}, a siloxane unit represented by the formula: R¹₂HSiO_{1/2}, and a siloxane unit represented by the formula: SiO_{4/2}; an organopolysiloxane copolymer comprising a siloxane unit represented by the formula: R¹₂HSiO_{1/2} and a siloxane unit represented by the formula: SiO_{4/2}; an organopolysiloxane copolymer comprising a siloxane unit represented by the formula: R¹₂HSiO_{2/2} and a siloxane unit represented by the formula: R¹SiO_{3/2} or a siloxane unit represented by the formula: HSiO_{3/2}; and mixtures of two or more of the above organopolysiloxanes. In the above formulas, R¹ is a monovalent hydrocarbon group other than the alkenyl group and can be exemplified by the same groups as given above.

The content of component (B) is an amount that provides from 0.5 to 10 moles, preferably from 0.5 to 5 moles, and more preferably from 0.5 to 3 moles of silicon-bonded hydrogen atoms in this component, in each case per 1 mole of alkenyl groups in component (A). The reasons for this are as follows: the obtained composition undergoes a satisfactory cure when the content of component (B) is at least the lower limit on the indicated range; on the other hand, timewise changes in the physical properties of the obtained silicone rubber can be inhibited when the content of component (B) is not more than the upper limit on the indicated range.

Component (C) is an adhesion promoter for the purpose of imparting adhesiveness to the composition. Although there are no limitations on component (C), see below, it is an organosilicon compound that contains silicon-bonded alkoxy group. The silicon-bonded alkoxy group in component (C) can be exemplified by methoxy, ethoxy, propoxy, and butoxy group wherein methoxy group is particularly preferred. The silicon-bonded organic groups in component (C) can be exemplified by alkyl groups such as methyl, ethyl, propyl, butyl, hexyl, octyl, and so forth; alkenyl groups such as vinyl, allyl, hexenyl, and so forth; aryl groups such as phenyl, tolyl, xylyl, and so forth; halogenated alkyl groups such as 3,3,3-trifluoropropyl, 3-chloropropyl, and so forth; functional organic groups such as 3-glycidoxypropyl, 3-methacryloxypropyl, 3-aminopropyl, N-(2-aminoethyl)-3-aminopropyl, and so forth; alkoxysilylalkyl groups such as trimethoxysilylethyl, methyldimethoxysilylethyl, and so forth; and the silicon-bonded hydrogen atoms.

Component (C) can be exemplified by a partial hydrolysis and condensation product from a single alkoxysilane or two or more alkoxysilanes such as 3-glycidoxypropyltrimethoxysilane, 3-glycidoxypropylmethyldimethoxysilane, 3-methacryloxypropyltrimethoxysilane, 3-methacryloxypropylmethyldimethoxysilane, 3-aminopropyltrimethoxysilane, 3-aminopropyltriethoxysilane, N-(2-aminoethyl)-3-aminopropyltrimethoxysilane, and so forth; methyl polysilicate, ethyl polysilicate, and organosiloxane oligomers such as an organosiloxane oligomer represented by the following general formula: 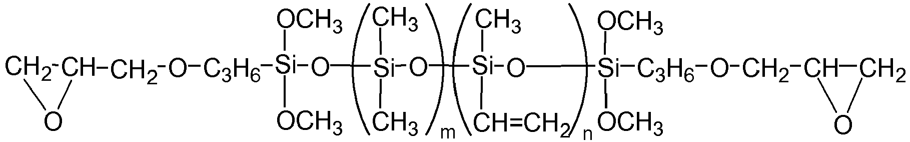 wherein **m** is an integer with a value of at least 0 and **n** is an integer with a value of at least 1; an organosiloxane oligomer represented by the following general formula: 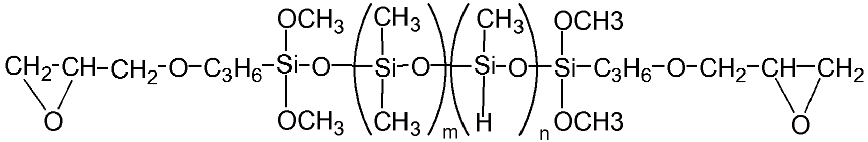 wherein **m** is an integer with a value of at least 0 and **n** is an integer with a value of at least 1; an organosiloxane oligomer represented by the following general formula: 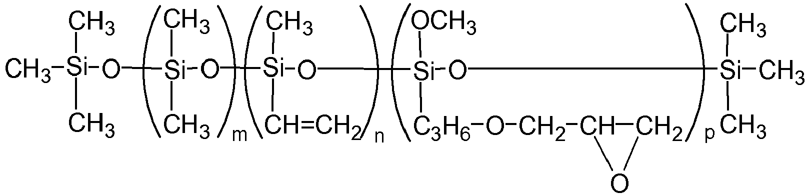 wherein **m** is an integer with a value of at least 0 and **n** and **p** are both integers with a value of at least 1; an organosiloxane oligomer represented by the following general formula: 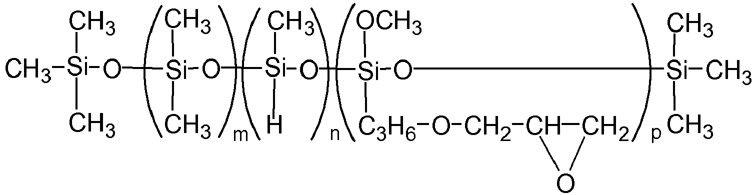 wherein **m** is an integer with a value of at least 0 and **n** and **p** are both integers with a value of at least 1; an organosiloxane oligomer represented by the following general formula: 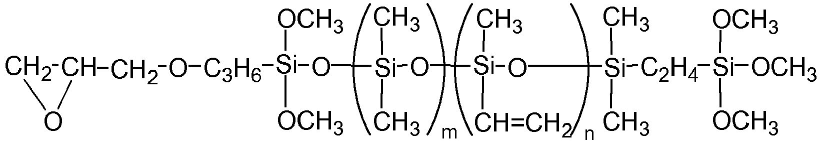 wherein **m** is an integer with a value of at least 0 and **n** is an integer with a value of at least 1; an organosiloxane oligomer represented by the following general formula: 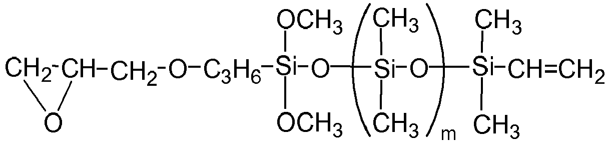 wherein **m** is an integer with a value of at least 0; an organosiloxane oligomer represented by the following general formula: 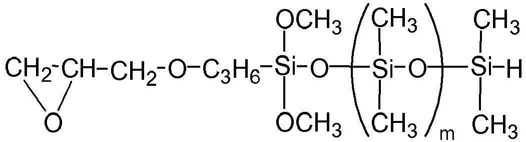 wherein **m** is an integer with a value of at least 0, and so forth.

Component (C) is particularly a mixture of the following components (i) and (ii), or a condensation reaction product from the following components (i) and (ii).
(i) an organosilicon compound that contains a silicon-bonded alkoxy group and that has a boiling point of at least 100°C.
(ii) a diorganosiloxane oligomer that contains a silicon-bonded hydroxyl group and at least one silicon-bonded alkenyl group in each molecule.

Component (i) has a boiling point, i.e., a boiling point at 1 atmosphere (the normal boiling point), of at least 100°C. The reason for this is as follows: an even greater reduction in the low-boiling fraction that volatilizes from the obtained composition during the course of its cure can be achieved when this boiling point is at least 100°C. Component (i) can be exemplified by 3-glycidoxypropyltrimethoxysilane, 3-glycidoxypropylmethyldimethoxysilane, 3-methacryloxypropyltrimethoxysilane, 3-methacryloxypropylmethyldimethoxysilane, 3-aminopropyltrimethoxysilane, 3-aminopropyltriethoxysilane, N-(2-aminoethyl)-3-aminopropyltrimethoxysilane, and so forth.

Component (ii) is a diorganosiloxane oligomer that contains the silicon-bonded hydroxyl group, i.e., the silanol group, and preferably has silanol groups in the amount of at most 9 mass%. The reason for this is as follows: the obtained composition exhibits an excellent adhesiveness when the content of silanol groups in component (ii) is not more than 9 mass%. Component (ii) can be exemplified by a methylvinylsiloxane oligomer endblocked by silanol groups at both molecular chain terminals, a co-oligomer of a dimethylsiloxane and a methylvinylsiloxane endblocked by silanol groups at both molecular chain terminals, a co-oligomer of a methylvinylsiloxane and a methylphenylsiloxane endblocked by silanol groups at both molecular chain terminals, and so forth.

Component (C) may be a mixture of components (i) and (ii) or may be a condensation reaction product from components (i) and (ii). While there are no limitations on the method of performing the condensation reaction between components (i) and (ii), the reaction is preferably carried out in the presence of a basic catalyst, e.g., potassium hydroxide, sodium hydroxide, and so forth.

The content of component (C) is at least 0.05 parts by mass, and preferably is at least 0.1 parts by mass, in each case per 100 parts by mass of component (A). The reason for this is as follows: the obtained composition exhibits an excellent adhesiveness when the content of component (C) is at least the lower limit on the indicated range.

The total quantity of components (B) and (C) in the composition must be in the range from 0.5 to 10 mass%, and preferably in the range from 0.5 to 7 mass%, and more preferably in the range from 0.5 to 3 mass%, in each case with reference to the total quantity of components (A), (B), and (C). The reasons for this are as follows: the obtained composition exhibits an excellent adhesiveness and curability when the total quantity of components (B) and (C), expressed with reference to the total quantity of components (A), (B), and (C), is at least the lower limit on the indicated range; on the other hand, the low-boiling fraction that volatilizes from the obtained composition during the course of its cure and the oil fraction that bleeds out from the composition during the course of its cure can both be suppressed at not more than the upper limit on the indicated range.

Component (D) is a thermally conductive filler for the purpose of imparting thermal conductivity to the composition. Component (D) can be exemplified by metal-based powders such as those of gold, silver, copper, aluminum, nickel, brass, shape-memory alloys, solder, and so forth; powders as provided by plating or vapor depositing a metal, e.g., gold, silver, nickel, copper, and so forth, on the surface of, for example, a ceramic powder, glass powder, quartz powder, or organic resin powder; metal oxide-based powders such as those of aluminum oxide, magnesium oxide, beryllium oxide, chromium oxide, zinc oxide, titanium oxide, crystalline silica, and so forth; metal nitride-based powders such as those of boron nitride, silicon nitride, aluminum nitride, and so forth; metal carbide-based powders such as those of boron carbide, titanium carbide, silicon carbide, and so forth; metal hydroxide-based powders such as those of aluminum hydroxide, magnesium hydroxide, and so forth; carbon-based powders such as carbon nanotubes, carbon microfibers, diamond powder, graphite, and so forth; and mixtures of two or more of the above. In particular, metal-based powders, metal oxide-based powders, and metal nitride-based powders are preferred for component (D) with silver powder, aluminum powder, aluminum oxide powder, zinc oxide powder, and aluminum nitride powder being specifically preferred. When electrical insulation is required of the composition, metal oxide-based powders and metal nitride-based powders are preferred wherein aluminum oxide powder, zinc oxide powder, and aluminum nitride powder are particularly preferred.

The shape of component (D) is not particularly limited, and it may be, for example, spherical, acicular, disk shaped, rod shaped, or irregularly shaped, wherein spherical and irregularly shaped are preferred. Although there are no limitations on the average particle size of component (D), it is preferably in the range from 0.01 to 100 µm and more preferably in the range from 0.01 to 50 µm

In addition, component (D) is surface treated with a silicon-type surface-treatment agent by blending methyltrimethoxysilane component (A) and component (D).

The method of surface treatment used here can be exemplified by by *in-situ* treatment methods, in which the surface of component (D) is treated by blending component (D) into a mixture of component (A) and the silicon-type surface-treatment agent or by blending the silicon-type surface-treatment agent into a mixture of components (A) and (D).

The content of component (D) is in the range from 100 to 2,000 parts by mass, and preferably in the range from 200 to 1,600 parts by mass, in each case per 100 parts by mass of component (A). The reasons for this are as follows: the resulting silicone rubber exhibits an excellent thermal conductivity when the content of component (D) is at least the lower limit on the indicated range; on the other hand, the handling characteristics of the obtained composition are excellent when the content of component (D) is not more than the upper limit on the indicated range.

Component (E) is a hydrosilylation reaction catalyst that functions to accelerate or promote the cure of the composition. Component (E) can be exemplified by platinum-based catalysts such as finely divided platinum, platinum black, platinum supported on finely divided silica, platinum supported on active carbon, chloroplatinic acid, platinum tetrachloride, alcohol solutions of chloroplatinic acid, complexes between platinum and olefin, complexes between platinum and an alkenylsiloxane such as divinyltetramethyldisiloxane, and so forth; by palladium-based catalysts such as tetrakis(triphenylphosphine)palladium, and so forth; by rhodium-based catalysts; and by thermoplastic resin powders having a particle size of less than 10 µm, for example, of a polystyrene resin, nylon resin, polycarbonate resin, silicone resin, and so forth, that incorporate a metal-based catalyst as listed in the above.

Component (E) is incorporated in a catalytic quantity, for example, preferably a quantity that provides, in mass units, from 0.1 to 500 ppm of metal atoms in component (E) with reference to component (A) and particularly preferably a quantity that provides, in mass units, from 1 to 50 ppm of metal atoms in component (E) with reference to component (A). The reasons for this are as follows: the obtained composition exhibits an excellent curability when the component (E) content is at least the lower limit on the indicated range; on the other hand, the obtained composition exhibits a satisfactory cure even at and below the upper limit on the indicated range.

The composition can be prepared by mixing components (A) to (E) to uniformity. The optional components for the composition can be exemplified by fumed silica, precipitated silica, titanium dioxide, carbon black, and glass fiber and by inorganic fillers as provided by subjecting the previously indicated inorganic fillers to a surface treatment with an organosilicon compound such as an organoalkoxysilane, organochlorosilane, organosilazane, and so forth.

The incorporation of a cure inhibitor is preferred in order to improve the handling characteristics of the composition. This cure inhibitor can be exemplified by alkyne alcohols such as 2-methyl-3-butyn-2-ol, 3,5-dimethyl-1-hexyn-3-ol, 2-phenyl-3-butyn-2-ol, and so forth; by ene-yne compounds such as 3-methyl-3-penten-1-yne, 3,5-dimethyl-3-hexen-1-yne, and so forth; and by benzotriazole. The content of these cure inhibitors is preferably in the range from 10 to 50,000 ppm in mass units with reference to component (A).

### Examples

The thermally conductive silicone rubber composition of the present invention is more particularly described using examples. The viscosity reported in the examples is the value measured at 25°C. The properties of the silicone rubbers obtained by curing the thermally conductive silicone rubber compositions were evaluated as followed.

### [Thermal conductivity]

A 10 cm × 5 cm × 1.5 cm silicone rubber block was fabricated by heating the thermally conductive silicone rubber composition for 1 hour at 150°C. The thermal conductivity of this silicone rubber was measured using a rapid thermal conductivity meter "QTM-500" from Kyoto Electronics Manufacturing Co., Ltd.

### [Content of cyclic siloxanes having from 4 to 20 siloxane units in organopolysiloxane]

The cyclic siloxanes having from 4 to 20 siloxane units in the organopolysiloxane were extracted with acetone and the quantity extracted was measured by gas chromatography using FID. The content of cyclic siloxanes in the organopolysiloxane was then determined from the quantity extracted.

### [Hardness]

The hardness of the silicone rubber produced as described above was measured using a type A durometer according to the method specified in JIS K 6253-1997, "Hardness testing methods for rubber, vulcanized or thermoplastic".

### [Tensile shear adhesive strength]

The tensile shear adhesive strength of the thermally conductive silicone rubber composition was measured according to the method specified in JIS K 6850: 1999, "Adhesives - Determination of tensile lap-shear strength of rigid-to-rigid bonded assemblies". Thus, using 100 mm × 20 mm × 1.6 mm aluminum adherends, a test specimen was fabricated by curing the silicone rubber composition by heating for 1 hour at 150°C with the adhesive layer comprising the silicone rubber composition being adjusted to 10 mm × 20 mm × 1 mm. The tensile shear adhesive strength of this test specimen was measured at a tensile rate of 50 mm/minute. The failure pattern for the adhesive was evaluated according to JIS K 6866: 1999, "Adhesives - Designation of main failure patterns".

In addition, the tensile shear adhesive strength was measured and the failure pattern was evaluated as above after a test specimen had been held for 250 hours in an 85°C/85% RH atmosphere.

### [Loss on heating]

Approximately 5 g of the thermally conductive silicone rubber composition was placed in an aluminum cup and the mass of the composition was precisely weighed to the fourth decimal place. The aluminum cup was then heated for 1 hour in a 150°C convection oven in order to cure the composition. This was followed by standing to cool for 30 minutes at room temperature; precise weighing of the mass of the silicone rubber to the fourth decimal place; and determination of the loss on heating in mass%.

### [Quantity of oil bleeding]

Oil bleeding by the oil component during the cure of the thermally conductive silicone rubber composition was evaluated using the test specimen shown in Figure 1. To fabricate the test specimen, 0.1 cc of the thermally conductive silicone rubber composition was placed on a ground glass plate **A** and was sandwiched with a ground glass plate **C** so as to bring the thickness of the composition to 1 mm. This test specimen was held at quiescence for 2 hours at room temperature, and the composition was subsequently cured by heating for 1 hour in a 150°C convection oven. The bleed-out width **a** of the oil fraction **D** that had bled out onto the glass plates around the circumference of the resulting silicone rubber **B** was measured and its area was calculated.

### [Example 1]

The following were mixed at room temperature using a Ross mixer: 100 parts by mass of a dimethylpolysiloxane endblocked by dimethylvinylsiloxy groups at both molecular chain terminals that had a viscosity of 2,000 mPa·s and contained 200 ppm of cyclic siloxanes having from 4 to 20 siloxane units, 4.3 parts by mass of methyltrimethoxysilane, and 330 parts by mass of an irregularly shaped finely divided aluminum oxide having an average particle size of 2.7 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 0.7 parts by mass of an adhesion promoter that had been prepared by premixing, at a mass ratio of 1 : 1, 3-glycidoxypropyltrimethoxysilane (boiling point = 290°C) with a co-oligomer of a dimethylsiloxane and a methylvinylsiloxane endblocked by silanol groups at both molecular chain terminals that had a viscosity of 20 mPa·s and had a silanol group content of 7 mass%; 1.9 part by mass of a copolymer of a dimethylsiloxane and a methylhydrogensiloxane endblocked by trimethylsiloxy groups at both molecular chain terminals that had a viscosity of 5 mPa·s, wherein this quantity provided 1.4 moles of silicon-bonded hydrogen atoms in this component per 1 mole of the vinyl groups in the dimethylpolysiloxane present in the silicone rubber base; 0.1 parts by mass of 2-phenyl-3-butyn-2-ol; and a complex between platinum and 1,3-divinyl-1,1,3,3-tetramethyldisiloxane, in a quantity that provided, in mass units, 30 ppm of platinum metal in this component with reference to the dimethylpolysiloxane present in the silicone rubber base. The proportion for the total amount of the copolymer of a dimethylsiloxane and a methylhydrogensiloxane and adhesion promoter in this thermally conductive silicone rubber composition with reference to the total amount of the dimethylpolysiloxane, copolymer of a dimethylsiloxane and a methylhydrogensiloxane, and adhesion promoter in the composition is 2.4 mass%. The properties of this thermally conductive silicone rubber composition and the thermally conductive silicone rubber are given in Table 1.

### [Example 2]

The following were mixed at room temperature using a Ross mixer: 100 parts by mass of a dimethylpolysiloxane endblocked by dimethylvinylsiloxy groups at both molecular chain terminals that had a viscosity of 2,000 mPa·s and contained 200 ppm of cyclic siloxanes having from 4 to 20 siloxane units, 3.7 parts by mass of methyltrimethoxysilane, and 270 parts by mass of an irregularly shaped finely divided aluminum oxide having an average particle size of 2.7 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 0.6 parts by mass of an adhesion promoter that had been prepared by premixing, at a mass ratio of 1 : 1, 3-glycidoxypropyltrimethoxysilane (boiling point = 290°C) with a co-oligomer of a dimethylsiloxane and a methylvinylsiloxane endblocked by silanol groups at both molecular chain terminals that had a viscosity of 20 mPa·s and a silanol group content of 7 mass%; 1.9 parts by mass of a copolymer of a dimethylsiloxane and a methylhydrogensiloxane endblocked by trimethylsiloxy groups at both molecular chain terminals that had a viscosity of 5 mPa·s, wherein this quantity provided 1.4 moles of silicon-bonded hydrogen atoms in this component per 1 mole of the vinyl groups in the dimethylpolysiloxane present in the silicone rubber base; 0.1 parts by mass of 2-phenyl-3-butyn-2-ol; and a complex between 1,3-divinyl-1,1,3,3-tetramethyldisiloxane and platinum, in a quantity that provided, in mass units, 30 ppm of platinum metal in this component with reference to the dimethylpolysiloxane present in the silicone rubber base. The proportion for the total amount of the copolymer of a dimethylsiloxane and a methylhydrogensiloxane and adhesion promoter in this thermally conductive silicone rubber composition with reference to the total amount of the dimethylpolysiloxane, copolymer of a dimethylsiloxane and a methylhydrogensiloxane, and adhesion promoter in the composition is 2.4 mass%. The properties of this thermally conductive silicone rubber composition and the thermally conductive silicone rubber are given in Table 1.

### [Example 3]

The following were mixed at room temperature using a Ross mixer: 100 parts by mass of a dimethylpolysiloxane endblocked by dimethylvinylsiloxy groups at both molecular chain terminals that had a viscosity of 2,000 mPa·s and contained 200 ppm cyclic siloxanes having from 4 to 20 siloxane units, 4.3 parts by mass of methyltrimethoxysilane, and 330 parts by mass of an irregularly shaped finely divided aluminum oxide having an average particle size of 2.7 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 0.2 parts by mass of an adhesion promoter that had been prepared by premixing, at a mass ratio of 1 : 1, 3-glycidoxypropyltrimethoxysilane (boiling point = 290°C) with a co-oligomer of a dimethylsiloxane and a methylvinylsiloxane endblocked by silanol groups at both molecular chain terminals that had a viscosity of 20 mPa·s and a silanol group content of 7 mass%; 0.6 parts by mass of a methylhydrogenpolysiloxane endblocked by trimethylsiloxy groups at both molecular chain terminals that had a viscosity of 5 mPa·s, wherein this quantity provided 1.1 moles of silicon-bonded hydrogen atoms in this component per 1 mole of the vinyl groups in the dimethylpolysiloxane present in the silicone rubber base; 0.1 parts by mass of 2-phenyl-3-butyn-2-ol; and a complex between 1,3-divinyl-1,1,3,3-tetramethyldisiloxane and platinum, in a quantity that provided, in mass units, 30 ppm of platinum metal in this component with reference to the dimethylpolysiloxane present in the silicone rubber base. The proportion for the total amount of the methylhydrogenpolysiloxane and adhesion promoter in this thermally conductive silicone rubber composition with reference to the total amount of the dimethylpolysiloxane, methylhydrogenpolysiloxane, and adhesion promoter in the composition is 0.8 mass%. The properties of this thermally conductive silicone rubber composition and the thermally conductive silicone rubber are given in Table 1.

### [Comparative Example 1]

The following were mixed at room temperature using a Ross mixer: 46 parts by mass of a dimethylpolysiloxane endblocked by dimethylvinylsiloxy groups at both molecular chain terminals that had a viscosity of 2,000 mPa·s and contained 200 ppm of cyclic siloxanes having from 4 to 20 siloxane units, 54 parts by mass of a dimethylpolysiloxane endblocked by dimethylvinylsiloxy groups at both molecular chain terminals that had a viscosity of 400 mPa·s and contained 200 ppm of cyclic siloxanes having from 4 to 20 siloxane units, 13.5 parts by mass of methyltrimethoxysilane, and 1,230 parts by mass of an irregularly shaped finely divided aluminum oxide having an average particle size of 3.6 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 1 part by mass of 3-glycidoxypropyltrimethoxysilane (boiling point = 290°C) and 1 part by mass of 3-methacryloxypropyltrimethoxysilane (boiling point = 107°C at 7 hPa); 14.8 parts by mass of a copolymer of a dimethylsiloxane and a methylhydrogensiloxane endblocked by dimethylhydrogensiloxy groups at both molecular chain terminals that had a viscosity of 20 mPa·s, wherein this quantity provided 1.5 moles of silicon-bonded hydrogen atoms in this component per 1 mole of the vinyl groups in the dimethylpolysiloxane mixture present in the silicone rubber base; 0.1 parts by mass of 2-phenyl-3-butyn-2-ol; and a complex between 1,3-divinyl-1,1,3,3-tetramethyldisiloxane and platinum, in a quantity that provided, in mass units, 35 ppm of platinum metal in this component with reference to the dimethylpolysiloxane mixture present in the silicone rubber base. The proportion for the total amount of the copolymer of a dimethylsiloxane and a methylhydrogensiloxane and adhesion promoter in this thermally conductive silicone rubber composition with reference to the total amount of the dimethylpolysiloxane mixture, copolymer of a dimethylsiloxane and a methylhydrogensiloxane, and adhesion promoter in the composition is 14.4 mass%. The properties of this thermally conductive silicone rubber composition and the thermally conductive silicone rubber are given in Table 1.

### [Comparative Example 2]

The following were mixed at room temperature using a Ross mixer: 70 parts by mass of a dimethylpolysiloxane endblocked by dimethylvinylsiloxy groups at both molecular chain terminals that had a viscosity of 9,000 mPa·s and contained 10 ppm of cyclic siloxanes having from 4 to 20 siloxane units, 30 parts by mass of a dimethylpolysiloxane endblocked by dimethylvinylsiloxy groups at both molecular chain terminals that had a viscosity of 2,000 mPa·s and contained 13,000 ppm of cyclic siloxane having from 4 to 20 siloxane units, 4 parts by mass of methyltrimethoxysilane, and 310 parts by mass of an irregularly shaped finely divided aluminum oxide having an average particle size of 2.7 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 5.2 parts by mass of an adhesion promoter that had been previously prepared by a base-catalyzed condensation reaction, at a mass ratio of 1 : 1, between 3-glycidoxypropyltrimethoxysilane (boiling point = 290°C) and a co-oligomer of a dimethylsiloxane and a methylvinylsiloxane endblocked by silanol groups at both molecular chain terminals that had a viscosity of 20 mPa·s and a silanol group content of 7 mass%; 13 parts by mass of a copolymer of a dimethylsiloxane and a methylhydrogensiloxane endblocked by dimethylhydrogensiloxy groups at both molecular chain terminals that had a viscosity of 5 mPa·s, wherein this quantity provided 4.9 moles of silicon-bonded hydrogen atoms in this component per 1 mole of the vinyl groups in the dimethylpolysiloxane mixture present in the silicone rubber base; and a complex between 1,3-divinyl-1,1,3,3-tetramethyldisiloxane and platinum, in a quantity that provided, in mass units, 30 ppm of platinum metal in this component with reference to the dimethylpolysiloxane mixture present in the silicone rubber base. The proportion for the total amount of the copolymer of a dimethylsiloxane and a methylhydrogensiloxane and adhesion promoter in this thermally conductive silicone rubber composition with reference to the total amount of the dimethylpolysiloxane mixture, copolymer of a dimethylsiloxane and a methylhydrogensiloxane, and adhesion promoter in the composition is 15.4 mass%. The properties of this thermally conductive silicone rubber composition and the thermally conductive silicone rubber are given in Table 1.

### [Comparative Example 3]

The following were mixed at room temperature using a Ross mixer: 100 parts by mass of a dimethylpolysiloxane endblocked by dimethylvinylsiloxy groups at both molecular chain terminals that had a viscosity of 2,000 mPa·s and contained 220 ppm of cyclic siloxanes having from 4 to 20 siloxane units, 3.7 parts by mass of methyltrimethoxysilane, and 280 parts by mass of an irregularly shaped finely divided aluminum oxide having an average particle size of 2.7 µm. A silicone rubber base was then prepared by heating and mixing for 1 hour at 150°C under reduced pressure.

A thermally conductive silicone rubber composition was then prepared by adding the following to this silicone rubber base and mixing to uniformity at room temperature: 0.04 parts by mass of an adhesion promoter that had been prepared by premixing, at a mass ratio of 1 : 1, 3-glycidoxypropyltrimethoxysilane (boiling point = 290°C) with a co-oligomer of a dimethylsiloxane and a methylvinylsiloxane endblocked by silanol groups at both molecular chain terminals that had a viscosity of 20 mPa·s and a silanol group content of 7 mass%; 0.4 parts by mass of a methylhydrogenpolysiloxane endblocked by trimethylsiloxy groups at both molecular chain terminals that had a viscosity of 20 mPa·s, wherein this quantity provided 0.6 moles of silicon-bonded hydrogen atoms in this component per 1 mole of the vinyl groups in the dimethylpolysiloxane present in the silicone rubber base; 0.1 parts by mass of 2-phenyl-3-butyn-2-ol; and a complex between 1,3-divinyl-1,1,3,3-tetramethyldisiloxane and platinum, in a quantity that provided, in mass units, 30 ppm of platinum metal in this component with reference to the dimethylpolysiloxane present in the silicone rubber base. The proportion for the total amount of the methylhydrogenpolysiloxane and adhesion promoter in this thermally conductive silicone rubber composition with reference to the total amount of the dimethylpolysiloxane, methylhydrogenpolysiloxane, and adhesion promoter in the composition is 0.4 mass%. The properties of this thermally conductive silicone rubber composition and the thermally conductive silicone rubber are given in Table 1.

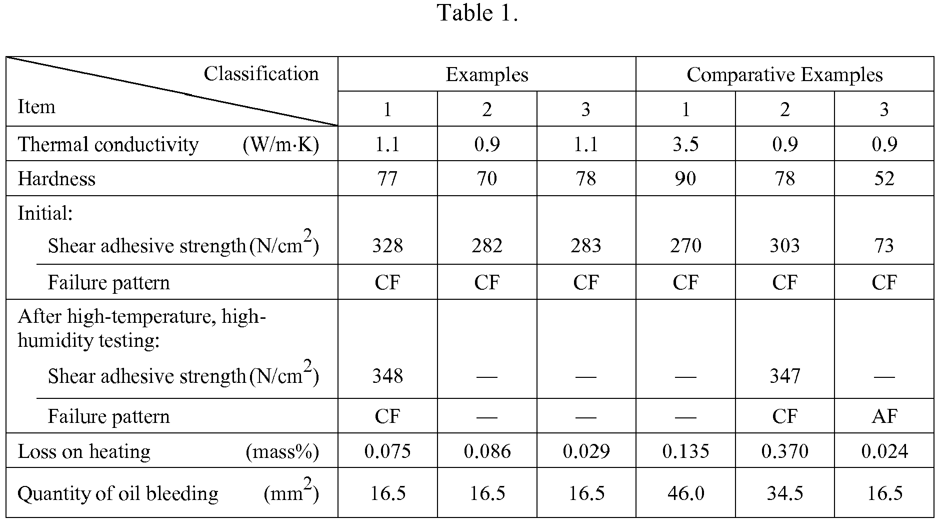

### Industrial Applicability

The thermally conductive silicone rubber composition of the present invention, because it is characterized by reduced oil fraction that bleeds out during the course of curing and by reduced low-boiling fraction that volatilizes during the course of curing, is well suited as a heat-dissipating adhesive for electrical components and electronic components; for example, it is well suited for application as an adhesive or potting material for hybrid ICs and for printed circuit boards mounted with electronic components such as transistors, ICs, memory elements, and so forth, as an adhesive for semiconductor devices and elements, and as an adhesive and/or sealant for engine mounts.

## Claims

1. A thermally conductive silicone rubber composition comprising:
(A) 100 parts by mass of an organopolysiloxane that contains at least two silicon-bonded alkenyl groups in each molecule, that does not contain a silicon-bonded hydroxyl group and does not contain a silicon-bonded alkoxy group, and that has a content of cyclic siloxanes having from 4 to 20 siloxane units of not more than 1,000 ppm in mass units;
(B) an organopolysiloxane that contains at least two silicon-bonded hydrogen atoms in each molecule and that does not contain a silicon-bonded alkenyl group, does not contain a silicon-bonded hydroxyl group, and does not contain a silicon-bonded alkoxy group, in an amount that provides from 0.5 to 10 moles of silicon-bonded hydrogen atoms in this component per 1 mole of the alkenyl groups in component (A);
(C) at least 0.05 parts by mass of an adhesion promoter, wherein the adhesion promoter is a mixture of the following components (i) and (ii) or a condensation reaction product from the following components (i) and (ii), wherein
(i) is an organosilicon compound that contains a silicon-bonded alkoxy group and that has a boiling point of at least 100°C; and
(ii) is a diorganosiloxane oligomer that contains a silicon-bonded hydroxyl group and at least one silicon-bonded alkenyl group in each molecule;
(D) 100 to 2,000 parts by mass of a thermally conductive filler that is surface treated *in situ* with a silicon-type surface-treatment agent by blending component (D) into a mixture of component (A) and methyltrimethoxysilane; or by blending methyltrimethoxysilane into a mixture of component (A) and component (D); and
(E) a catalytic quantity of a hydrosilylation reaction catalyst;
wherein the total quantity of components (B) and (C) is from 0.5 to 10 mass% of the total quantity of components (A), (B), and (C).

2. The thermally conductive silicone rubber composition according to claim 1, wherein component (D) is a metal-based powder, a metal oxide-based powder, or a metal nitride-based powder.

3. The thermally conductive silicone rubber composition according to claim 1, wherein component (D) is a silver powder, an aluminum powder, an aluminum oxide powder, a zinc oxide powder, or an aluminum nitride powder.

## Patentansprüche

1. Eine wärmeleitende Silikonkautschukzusammensetzung, die Folgendes beinhaltet:
(A) 100 Massenteile eines Organopolysiloxans, das mindestens zwei siliciumgebundene Alkenylgruppen in jedem Molekül enthält, das keine siliciumgebundene Hydroxylgruppe enthält und keine siliciumgebundene Alkoxygruppe enthält, und das einen Gehalt an cyclischen Siloxanen mit 4 bis 20 Siloxaneinheiten von nicht mehr als 1000 ppm in Masseneinheiten aufweist;
(B) ein Organopolysiloxan, das mindestens zwei siliciumgebundene Wasserstoffatome in jedem Molekül enthält und das keine siliciumgebundene Alkenylgruppe enthält, keine siliciumgebundene Hydroxylgruppe enthält und keine siliciumgebundene Alkoxygruppe enthält, in einer Menge, die von 0,5 bis 10 Mol siliciumgebundene Wasserstoffatome in dieser Komponente pro 1 Mol der Alkenylgruppen in Komponente (A) bereitstellt;
(C) mindestens 0,05 Massenteile eines Haftvermittlers, wobei der Haftvermittler eine Mischung der folgenden Komponenten (i) und (ii) oder ein Kondensationsreaktionsprodukt der folgenden Komponenten (i) und (ii) ist, wobei
(i) eine siliciumorganische Verbindung ist, die eine siliciumgebundene Alkoxygruppe enthält und einen Siedepunkt von mindestens 100 °C aufweist; und
(ii) ein Diorganosiloxanoligomer ist, das eine siliciumgebundene Hydroxylgruppe und mindestens eine siliciumgebundene Alkenylgruppe in jedem Molekül enthält;
(D) 100 bis 2000 Massenteile eines wärmeleitendem Füllstoffs, der *in situ* mit einem Oberflächenbehandlungsmittel des Siliciumtyps durch das Mischen von Komponente (D) in eine Mischung von Komponente (A) und Methyltrimethoxysilan oder durch das Mischen von Methyltrimethoxysilan in eine Mischung von Komponente (A) und Komponente (D) oberflächenbehandelt wird; und
(E) eine katalytische Menge eines Hydrosilylierungsreaktionskatalysators;
wobei die Gesamtmenge der Komponenten (B) und (C) von 0,5 bis 10 Massenprozent der Gesamtmenge der Komponenten (A), (B) und (C) beträgt.

2. Wärmeleitende Silikonkautschukzusammensetzung gemäß Anspruch 1, wobei Komponente (D) ein auf Metall basierendes Pulver, ein auf Metalloxid basierendes Pulver oder ein auf Metallnitrid basierendes Pulver ist.

3. Wärmeleitende Silikonkautschukzusammensetzung gemäß Anspruch 1, wobei Komponente (D) ein Silberpulver, ein Aluminiumpulver, ein Aluminiumoxidpulver, ein Zinkoxidpulver oder ein Aluminiumnitridpulver ist.

## Revendications

1. Une composition de caoutchouc de silicone thermiquement conducteur comprenant :
(A) 100 parties en masse d'un organopolysiloxane qui contient au moins deux groupes alcényle liés au silicium dans chaque molécule, qui ne contient pas de groupe hydroxyle lié au silicium et qui ne contient pas de groupe alcoxy lié au silicium, et qui a une teneur en siloxanes cycliques ayant de 4 à 20 unités siloxane n'excédant pas 1 000 ppm en unités de masse ;
(B) un organopolysiloxane qui contient au moins deux atomes d'hydrogène liés au silicium dans chaque molécule et qui ne contient pas de groupe alcényle lié au silicium, qui ne contient pas de groupe hydroxyle lié au silicium, et qui ne contient pas de groupe alcoxy lié au silicium, en une quantité qui fournit de 0,5 à 10 moles d'atomes d'hydrogène liés au silicium dans ce constituant pour 1 mole des groupes alcényle dans le constituant (A) ;
(C) au moins 0,05 partie en masse d'un promoteur d'adhérence, où le promoteur d'adhérence est un mélange des constituants (i) et (ii) suivants ou un produit de réaction de condensation des constituants (i) et (ii) suivants, où
(i) est un composé organosilicium qui contient un groupe alcoxy lié au silicium et qui a un point d'ébullition d'au moins 100 °C ; et
(ii) est un oligomère diorganosiloxane qui contient un groupe hydroxyle lié au silicium et au moins un groupe alcényle lié au silicium dans chaque molécule ;
(D) de 100 à 2 000 parties en masse d'une charge thermiquement conductrice qui est traitée en surface *in situ* avec un agent de traitement de surface de type silicium en mélangeant de façon homogène le constituant (D) dans un mélange du constituant (A) et de méthyltriméthoxysilane ; ou en mélangeant de façon homogène du méthyltriméthoxysilane dans un mélange du constituant (A) et du constituant (D) ; et
(E) une quantité catalytique d'un catalyseur de réaction d'hydrosilylation ;
où la quantité totale des constituants (B) et (C) va de 0,5 à 10 % en masse de la quantité totale des constituants (A), (B), et (C).

2. La composition de caoutchouc de silicone thermiquement conducteur selon la revendication 1, où le constituant (D) est une poudre à base de métal, une poudre à base d'oxyde métallique, ou une poudre à base de nitrure métallique.

3. La composition de caoutchouc de silicone thermiquement conducteur selon la revendication 1, où le constituant (D) est une poudre d'argent, une poudre d'aluminium, une poudre d'oxyde d'aluminium, une poudre d'oxyde de zinc, ou une poudre de nitrure d'aluminium.
